# EUROPEAN PATENT APPLICATION

(11) **EP 4 839 059 A1**
(43) Date of publication of application: **11.11.2026**
(21) Application number: 25824444.1
(22) Date of filing: 27.02.2025
(51) Int. Cl.: H10F 77/20

(54) **BACK-CONTACT SOLAR CELL, CELL ASSEMBLY, AND PHOTOVOLTAIC SYSTEM**

(30) Priority: 24.06.2024 CN 202410821423
(71) Applicant: Zhejiang Aiko Solar Energy Technology Co., Ltd., Yiwu, Jinhua Zhejiang 322000 (CN)
(72) Inventor: WANG, Yongqian, Jinhua, Zhejiang 322000 (CN); CHEN, Gang, Jinhua, Zhejiang 322000 (CN)
(74) Representative: EP&C
(86) International application number: PCT/CN2025/079644
(87) International publication number: WO 2026/001049

(57) **Abstract**

The present disclosure is suitable for the technical field of solar cells, providing a back contact solar cell, a cell assembly, and a photovoltaic system. The back contact solar cell includes: a silicon substrate, having a back side and a front side, which are opposite to each other; a P-type doped polysilicon layer, located in a first region of the back side of the silicon substrate; an N-type doped polysilicon layer, located in a second region of the back side of the silicon substrate; a first metal electrode disposed in the first region and in contact with the P-type doped polysilicon layer; and a second metal electrode disposed in the second region and in contact with the N-type doped polysilicon layer, where a depth of a metallic crystal of the first metal electrode entering the P-type doped polysilicon layer is greater than a depth of a metallic crystal of the second metal electrode entering the N-type doped polysilicon layer. The back contact solar cell of the present disclosure can improve a contact effect of the metal electrode and the P-type doped polysilicon layer, thereby improving the conductive performance of the metal electrode and the P-type doped polysilicon layer, and improving cell conversion efficiency.

## Description

### Priority Information

This disclosure claims priority to and benefits of Chinese Patent Application No. 202410821423.3 filed to the China National Intellectual Property Administration on June 24, 2024, the disclosure of which is hereby incorporated by reference in its entirety.

### Technical Field

The present disclosure relates to the technical field of solar cells, and in particular, to a back contact solar cell, a cell assembly, and a photovoltaic system.

### Background Art

Electricity generated by solar cells is a sustainable clean energy source. By virtue of a photovoltaic effect of a semiconductor, sunlight can be converted into electric energy. Conversion efficiency is an important indicator of the performance of solar cells. In an Interdigitated back contact (IBC) solar cell, a positive/negative electrode is designed on a back side of the cell, so that a front surface is not at all shielded by a metal gate line, thereby completely eradicating an optical loss caused by the shielding of the metal gate line. In addition, a width of the electrode can be designed wider than a conventional electrode, such that a series resistance loss is reduced, thereby significantly improving a conversion efficiency of the cell. Furthermore, since the front side is designed with no electrodes, a product has a more beautiful appearance, and is applicable to a plurality of application scenarios.

In the related art, P regions and N regions, which are arranged in a staggered manner, are formed on the back side of the back contact solar cell. Generally, a depth of a metal electrode corresponding to the P region entering a P-type doped polysilicon layer is equal to a depth of a metal electrode corresponding to the N region entering an N-type doped polysilicon layer, and the relatively-poor contact effect between the P-type doped polysilicon layer and the metal electrode causing the P-type doped polysilicon layer to have a poor conductive performance with the metal electrode, and thus affecting the conversion efficiency of the cell.

### Summary

The present disclosure provides a back contact solar cell, so as to solve the problem of a poor contact effect of a P-type doped polysilicon layer and a metal electrode in a back contact solar cell in the related art, thus affecting cell conversion efficiency.

The present disclosure is implemented in following way, wherein providing a back contact solar cell, including:
a silicon substrate, including a back side and a front side, which are opposite to each other;
a P-type doped polysilicon layer, located in a first region of the back side of the silicon substrate;
an N-type doped polysilicon layer, located in a second region of the back side of the silicon substrate, wherein the first region is different from the second region;
a first metal electrode disposed in the first region and in contact with the P-type doped polysilicon layer; and
a second metal electrode disposed in the second region and in contact with the N-type doped polysilicon layer;
wherein a depth of a metallic crystal of the first metal electrode entering the P-type doped polysilicon layer is greater than a depth of a metallic crystal of the second metal electrode entering the N-type doped polysilicon layer.

In some embodiments, a ratio of the depth of the metallic crystal of the first metal electrode entering the P-type doped polysilicon layer to the depth of the metallic crystal of the second metal electrode entering the N-type doped polysilicon layer is 1-4, and is not equal to 1.

In some embodiments, a ratio of the depth of the metallic crystal of the first metal electrode entering the P-type doped polysilicon layer to the depth of the metallic crystal of the second metal electrode entering the N-type doped polysilicon layer is 1-2, and is not equal to 1.

In some embodiments, the depth of the metallic crystal of the first metal electrode entering the P-type doped polysilicon layer is 2-300 nm; and the depth of the metallic crystal of the second metal electrode entering the N-type doped polysilicon layer is 1-200 nm.

In some embodiments, materials of the first metal electrode and materials of the second metal electrode both include silver, at least one kind of glass frit, and at least one kind of organic material, and a mass content of the at least one kind of glass frit in the first metal electrode is greater than a mass content of the at least one kind of glass frit in the second metal electrode.

In some embodiments, a refractive index of the P-type doped polysilicon layer is less than a refractive index of the N-type doped polysilicon layer.

In some embodiments, the back contact a solar cell further includes back-side passivation film layers that is located on a back side of the P-type doped polysilicon layer and a back side of the N-type doped polysilicon layer. The metallic crystal of the first metal electrode enters the P-type doped polysilicon layer by passing through the back-side passivation film layer, and the metallic crystal of the second metal electrode enters the N-type doped polysilicon layer by passing through the back-side passivation film layer.

In some embodiments, an average grain size of the P-type doped polysilicon layer is greater than an average grain size of the N-type doped polysilicon layer.

In some embodiments, a ratio of the average grain size of the P-type doped polysilicon layer to the average grain size of the N-type doped polysilicon layer is 1-4, and is not equal to 1.

In some embodiments, a thickness of the P-type doped polysilicon layer is greater than a thickness of the N-type doped polysilicon layer.

In some embodiments, a ratio of the thickness of the P-type doped polysilicon layer to the thickness of the N-type doped polysilicon layer is 1-2, and is not equal to 1.

The present disclosure further provides a cell assembly, including the above back contact solar cell.

The present disclosure further provides a photovoltaic system, including the above cell assembly.

In the back contact solar cell provided in the present disclosure, by setting the depth of the metallic crystal of the first metal electrode entering the P-type doped polysilicon layer to be greater than the depth of the metallic crystal of the second metal electrode entering the N-type doped polysilicon layer, with the depth of the metallic crystal of the second metal electrode entering the N-type doped polysilicon layer unchanged, a contact area of the metallic crystal of the first metal electrode and the P-type doped polysilicon layer can be increased by increasing the depth of the metallic crystal of the first metal electrode entering the P-type doped polysilicon layer, such that a contact effect of the first metal electrode and the P-type doped polysilicon layer can be improved, and a desirable ohmic contact can be realized, then the conductive performance of the first metal electrode and the P-type doped polysilicon layer can be improved, thereby improving cell conversion efficiency.

### Brief Description of the Drawings

Fig. 1 is a schematic diagram of a back contact solar cell according to embodiments of the present disclosure.
Fig. 2 is a schematic diagram of partial structure of a back contact solar cell according to embodiments of the present disclosure.
Fig. 3 is a Scanning Electronic Microscopy (SEM) picture of a metallic crystal of a first metal electrode entering a P-type doped polysilicon layer in a back contact solar cell according to embodiments of the present disclosure.
Fig. 4 is an SEM picture of a metallic crystal of a second metal electrode entering an N-type doped polysilicon layer in a back contact solar cell according to embodiments of the present disclosure.

### Detailed Description of the Embodiments

To make the objectives, technical solutions and advantages of the present disclosure clearer, the present disclosure is further described in detail. It should be understood that specific embodiments described herein are merely intended to explain the disclosure instead of limiting the disclosure.

In a back contact solar cell provided in the embodiments of the present disclosure, by setting a depth of a metallic crystal of a first metal electrode entering a P-type doped polysilicon layer to be greater than a depth of a metallic crystal of a second metal electrode entering an N-type doped polysilicon layer, compared to the second metal electrode, a contact area of the metallic crystal of the first metal electrode and the P-type doped polysilicon layer can be increased by increasing the depth of the metallic crystal of the first metal electrode entering the P-type doped polysilicon layer, such that a contact effect of the first metal electrode and the P-type doped polysilicon layer can be improved, and a desirable ohmic contact can be realized, then the conductive performance of the first metal electrode and the P-type doped polysilicon layer can be improved, thereby improving cell conversion efficiency.

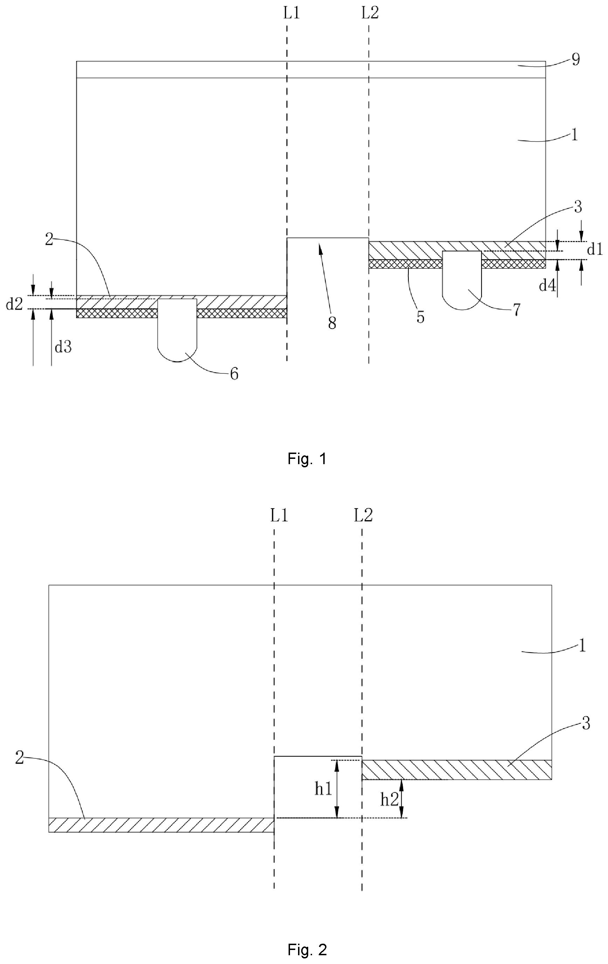

Referring to Fig. 1, a back contact solar cell provided in the embodiments of the present disclosure includes:
a silicon substrate1, and the silicon substrate 1 has a back side and a front side, which are provided opposite to each other;
a P-type doped polysilicon layer 2, that is located in a first region of the back side of the silicon substrate 1;
an N-type doped polysilicon layer 3, that is located in a second region of the back side of the silicon substrate 1, where the first region is different from the second region.
a first metal electrode 6, that is disposed in the first region and in contact with the P-type doped polysilicon layer 2;
a second metal electrode 7, that is disposed in the second region and in contact with the N-type doped polysilicon layer 3;
in which a depth d3 of a metallic crystal of the first metal electrode 6 entering the P-type doped polysilicon layer 2 is greater than a depth d4 of a metallic crystal of the second metal electrode 7 entering the N-type doped polysilicon layer 3.

As shown in Fig. 1, the back side of the silicon substrate 1 is a lower side, and the front side of it is an upper side. A dashed line L1 and a dashed line L2 are only used for distinguishing the first region and the second region, and are not actually present in the back contact solar cell. Referring to Fig. 1, a region on a left side of the dashed line L1 is the first region, a region on a right side of the dashed line L2 is the second region, and the first region and the second region are different regions. The P-type doped polysilicon layer 2 is located in the first region of the back side of the silicon substrate 1, and the N-type doped polysilicon layer 3 is located in the second region of the back side of the silicon substrate 1. The P-type doped polysilicon layer 2 is located in the region on the left side of the dashed line L1 of the back side of the silicon substrate 1; and the N-type doped polysilicon layer 3 is located in the region on the right side of the dashed line L2 of the back side of the silicon substrate 1.

In the back contact solar cell provided in the embodiments of the present disclosure, by setting the depth d3 of the metallic crystal of the first metal electrode 6 entering the P-type doped polysilicon layer 2 to be greater than the depth d4 of the metallic crystal of the second metal electrode 7 entering the N-type doped polysilicon layer 3, with the depth of the metallic crystal of the second metal electrode 7 entering the N-type doped polysilicon layer 3 unchanged, a contact area of the metallic crystal of the first metal electrode 6 and the P-type doped polysilicon layer 2 can be increased by increasing the depth of the metallic crystal of the first metal electrode 6 entering the P-type doped polysilicon layer 2, such that a contact effect of the first metal electrode 6 and the P-type doped polysilicon layer 2 can be improved, and the conductive performance of the first metal electrode 6 and the P-type doped polysilicon layer 2 can be improved, thereby improving cell conversion efficiency.

In the embodiments of the present disclosure, the first metal electrode 6 and the second metal electrode 7 can be specifically printed by using slurries with different burning-through capabilities, so as to control the depths of the metallic crystals of the metal electrodes entering the P-type doped polysilicon layer 2 and the N-type doped polysilicon layer 3. Specifically, the burning-through capability of a first slurry used by the first metal electrode 6 is greater than the burning-through capability of a second slurry used by the second metal electrode 7, such that the depth of the metallic crystal of the first metal electrode 6 entering the P-type doped polysilicon layer 2 can be greater than the depth of the metallic crystal of the second metal electrode 7 entering the N-type doped polysilicon layer 3.

As an embodiment of the present disclosure, the first metal electrode 6 and the second metal electrode 7 both include silver, at least one kind of glass frit, and at least one kind of organic material, and a mass content of the at least one kind of glass frit in the first metal electrode 6 is greater than a mass content of the at least one kind of glass frit in the second metal electrode 7.

In this embodiment, the first metal electrode 6 and the second metal electrode 7 both include the silver, the at least one kind of glass frit, and the at least one kind of organic material. The at least one kind of glass frit includes at least one of PbO, Bi₂O₃, ZnO, SiO₂, or MgO, and the mass content of the at least one kind of glass frit in the first metal electrode 6 is greater than the mass content of the at least one kind of glass frit in the second metal electrode 7, such that the burning-through capability of the first slurry used by the first metal electrode 6 is greater than the burning-through capability of the second slurry used by the second metal electrode 7, thereby causing the depth of the metallic crystal of the first metal electrode 6 entering the P-type doped polysilicon layer 2 to be greater than the depth of the metallic crystal of the second metal electrode 7 entering the N-type doped polysilicon layer 3.

As an embodiment of the present disclosure, the depth d3 of the metallic crystal of the first metal electrode 6 entering the P-type doped polysilicon layer 2 is 2-300 nm; and the depth d4 of the metallic crystal of the second metal electrode 7 entering the N-type doped polysilicon layer 3 is 1-200 nm. The depth d3 of the metallic crystal of the first metal electrode 6 entering the P-type doped polysilicon layer 2 and the depth d4 of the metallic crystal of the second metal electrode 7 entering the N-type doped polysilicon layer 3 can be flexibly set according to actual requirements. The depth d3 of the metallic crystal of the first metal electrode 6 entering the P-type doped polysilicon layer 2 and the depth d4 of the metallic crystal of the second metal electrode 7 entering the N-type doped polysilicon layer 3 can both be obtained through measurement using a SEM.

For example, the depth d3 of the metallic crystal of the first metal electrode 6 entering the P-type doped polysilicon layer 2 can be 2 nm, 10 nm, 30 nm, 50 nm, 70 nm, 90 nm, 100 nm, 110 nm, 120 nm, 140 nm, 160 nm, 200 nm, 240 nm, 260 nm, 280 nm, or 300 nm. The depth d4 of the metallic crystal of the second metal electrode 7 entering the N-type doped polysilicon layer 3 can be 1 nm, 5 nm, 20 nm, 30 nm, 50 nm, 80 nm, 90 nm, 100 nm, 120 nm, 130 nm, 150 nm, 160 nm, 180 nm, 190 nm, or 200 nm.

As an embodiment of the present disclosure, a ratio of the depth d3 of the metallic crystal of the first metal electrode 6 entering the P-type doped polysilicon layer 2 to the depth d4 of the metallic crystal of the second metal electrode 7 entering the N-type doped polysilicon layer 3 is 1-4, and is not equal to 1.

In this embodiment, the ratio of the depth d3 of the metallic crystal of the first metal electrode 6 entering the P-type doped polysilicon layer 2 to the depth d4 of the metallic crystal of the second metal electrode 7 entering the N-type doped polysilicon layer 3 is greater than 1 and less than or equal to 4, such that metalization damages to the P-type doped polysilicon layer 2 can be reduced, sheet resistance of the P-type doped polysilicon layer is reduced, cell efficiency is improved, and a desirable contact of the second metal electrode and the P-type doped polysilicon layer 2 can be ensured, thereby improving cell conversion efficiency.

For example, the ratio of the depth d3 of the metallic crystal of the first metal electrode 6 entering the P-type doped polysilicon layer 2 to the depth d4 of the metallic crystal of the second metal electrode 7 entering the N-type doped polysilicon layer 3 can be as following:
1.01, 1.05, 1.1, 1.15, 1.2, 1.25, 1.3, 1.35, 1.4, 1.45, 1.5, 1.55, 1.6, 1.65, 1.7, 1.75, 1.8, 1.85, 1.9, 1.92, 2, 2.2, 2.5, 2.7, 2.8, 3.0, 3.3, 3.5, or 4.0.

As an embodiment of the present disclosure, the ratio of the depth d3 of the metallic crystal of the first metal electrode 6 entering the P-type doped polysilicon layer 2 to the depth d4 of the metallic crystal of the second metal electrode 7 entering the N-type doped polysilicon layer 3 is 1-2, and is not equal to 1.

In this embodiment, the ratio of the depth d3 of the metallic crystal of the first metal electrode 6 entering the P-type doped polysilicon layer 2 to the depth d4 of the metallic crystal of the second metal electrode 7 entering the N-type doped polysilicon layer 3 is greater than 1 and less than or equal to 2, such that the desirable contact of the first metal electrode and the P-type doped polysilicon layer 2 can be ensured, thereby facilitating the process control of the depth d3 of the metallic crystal of the first metal electrode 6 entering the P-type doped polysilicon layer 2 and the depth d4 of the metallic crystal of the second metal electrode 7 entering the N-type doped polysilicon layer 3.

As an embodiment of the present disclosure, the depth of the metallic crystal of the first metal electrode 6 entering the P-type doped polysilicon layer 2 is 2-300 nm; and the depth of the metallic crystal of the second metal electrode 7 entering the N-type doped polysilicon layer 3 is 1-200 nm, such that the depth of the metallic crystal of the first metal electrode 6 entering the P-type doped polysilicon layer 2 and the depth of the metallic crystal of the second metal electrode 7 entering the N-type doped polysilicon layer 3 are prevented from being too deep or too shallow. The depth d3 of the metallic crystal of the first metal electrode 6 entering the P-type doped polysilicon layer 2 and the depth d4 of the metallic crystal of the second metal electrode 7 entering the N-type doped polysilicon layer 3 can flexibly set according to actual requirements.

For example, the depth d3 of the metallic crystal of the first metal electrode 6 entering the P-type doped polysilicon layer 2 can be 2 nm, 10 nm, 30 nm, 50 nm, 70 nm, 90 nm, 100 nm, 110 nm, 120 nm, 140 nm, 160 nm, 200 nm, 240 nm, 260 nm, 280 nm, or 300 nm. The depth d4 of the metallic crystal of the second metal electrode 7 entering the N-type doped polysilicon layer 3 can be 1 nm, 5 nm, 20 nm, 30 nm, 50 nm, 80 nm, 90 nm, 100 nm, 120 nm, 130 nm, 150 nm, 160 nm, 180 nm, 190 nm, or 200 nm.

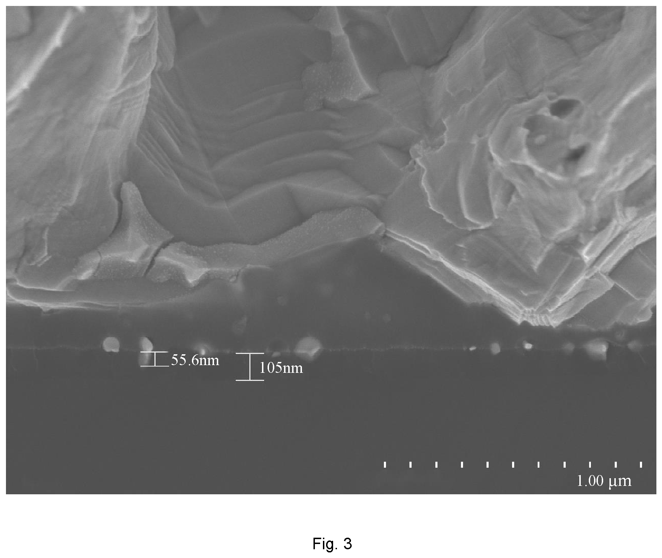

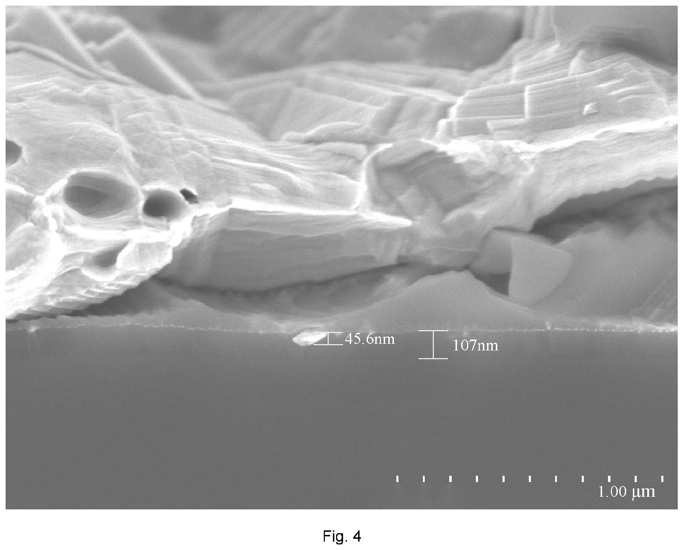

Exemplarily, as shown in Fig. 3, a thickness d2 of the P-type doped polysilicon layer 2 is 105 nm, and the depth d3 of the metallic crystal of the first metal electrode 6 entering the P-type doped polysilicon layer 2 is 55.6 nm; and as shown in Fig. 4, a thickness of the N-type doped polysilicon layer 3 is 107 nm, and the depth d4 of the metallic crystal of the second metal electrode 7 entering the N-type doped polysilicon layer 3 is 45.6 nm.

As an embodiment of the present disclosure, the thickness d1 of the N-type doped polysilicon layer 3 is greater than the thickness d2 of the P-type doped polysilicon layer 2.

In this embodiment, by setting the thickness d1 of the N-type doped polysilicon layer 3 to be greater than the thickness d2 of the P-type doped polysilicon layer 2, compared with the thickness d1 of the N-type doped polysilicon layer 3, the thickness d2 of the P-type doped polysilicon layer 2 is reduced, then etching difficulty of the P-type doped polysilicon layer 2 is reduced, and a patterning process difficulty is reduced, thereby facilitating patterning process on the P-type doped polysilicon layer. Furthermore, by reducing the thickness d2 of the P-type doped polysilicon layer 2, the difficulty of boron diffusion can be reduced, then the boron diffusion process is achieved, and the P-type doped polysilicon layer 2 with a high concentration is prepared. Furthermore, the thickness d1 of the N-type doped polysilicon layer 3 is greater than the thickness d2 of the P-type doped polysilicon layer 2, namely the N-type doped polysilicon layer 3 is thicker than the P-type doped polysilicon layer 2, such that a passivation effect can be improved, thereby improving cell efficiency.

As an embodiment of the present disclosure, a ratio of the thickness d1 of the N-type doped polysilicon layer 3 to the thickness d2 of the P-type doped polysilicon layer 2 is 1-2, and is not equal to 1.

In this embodiment, the ratio of the thickness d1 of the N-type doped polysilicon layer 3 to the thickness d2 of the P-type doped polysilicon layer 2 is greater than 1 and less than or equal to 2, such that etching difficulty of the P-type doped polysilicon layer 2 can be reduced, the patterning process on the P-type doped polysilicon layer 2 is facilitated, the boron diffusion process is facilitated, the difficulty of boron diffusion is reduced, and the P-type doped polysilicon layer 2 with a high concentration can be prepared.

For example, the ratio of the thickness d1 of the N-type doped polysilicon layer 3 to the thickness d2 of the P-type doped polysilicon layer 2 can be as following:
1.01, 1.05, 1.1, 1.15, 1.2, 1.25, 1.3, 1.35, 1.4, 1.45, 1.5, 1.55, 1.6, 1.65, 1.7, 1.75, 1.8, 1.85, 1.9, 1.92, or 2.

Optionally, when the ratio of the d1 to the d2 is 1to 2, the thickness d1 of the N-type doped polysilicon layer 3 is 100 nm to 600 nm, and the thickness d2 of the P-type doped polysilicon layer 2 can be 50 nm to 300 nm. The d1 and the d2 are within the above ranges, such that the P-type doped polysilicon layer 2 and the N-type doped polysilicon layer 3 both are easy to achieve a good doping effect, and both have a good passivation effect, small metalization damages and small contact resistance are ensured at the same time, and costs are relatively low. Furthermore, the etching difficulty of the P-type doped polysilicon can be reduced to facilitate the patterning process of the P-type doped polysilicon, such that the P-type doped polysilicon layer 2 is prepared, the boron diffusion process is facilitated, the difficulty of boron diffusion is reduced, and the P-type doped polysilicon layer 2 with a high concentration can be prepared.

As an embodiment of the present disclosure, a refractive index of the P-type doped polysilicon layer 2 is less than a refractive index of the N-type doped polysilicon layer 3.

It can be understood that, the refractive index of the N-type doped polysilicon layer 3 is unchanged, and the refractive index of the P-type doped polysilicon layer 2 is decreased, causing the refractive index of the P-type doped polysilicon layer 2 to be less than the refractive index of the N-type doped polysilicon layer 3, such that a parasitic absorption effect of the P-type doped polysilicon layer can be reduced, and then the cell efficiency can be further improved. The refractive index of the P-type doped polysilicon layer 2 and the refractive index of the N-type doped polysilicon layer 3 can be flexibly set according to actual requirements, as long as the refractive index of the P-type doped polysilicon layer 2 is less than the refractive index of the N-type doped polysilicon layer 3.

As an embodiment of the present disclosure, an average grain size of the P-type doped polysilicon layer 2 is greater than an average grain size of the N-type doped polysilicon layer 3.

In this embodiment, the average grain size of the P-type doped polysilicon layer 2 and the average grain size of the N-type doped polysilicon layer 3 can be obtained through measurement using an X-Ray Diffraction (XRD) instrument, a Scanning Electronic Microscopy (SEM), or a Transmission Electron Microscope (TEM). The average grain size of the P-type doped polysilicon layer 2 is greater than the average grain size of the N-type doped polysilicon layer 3, which means an average value of all grain sizes of the P-type doped polysilicon layer 2 per unit area is greater than an average value of all grain sizes of the N-type doped polysilicon layer 3 per unit area. That is to say, within the unit area, there are more grains in the N-type doped polysilicon layer 3, and compared to the N-type doped polysilicon layer 3 per unit area, the P-type doped polysilicon layer 2 per unit area has fewer grain boundaries, such that a compact degree of the P-type doped polysilicon layer 2 can be increased, the sheet resistance of the P-type doped polysilicon layer 2 can be reduced, and current loss can be reduced, thereby further improving the cell efficiency. Furthermore, the P-type doped polysilicon layer 2 has fewer grain boundaries, such that the metalization damages to the P-type doped polysilicon layer 2 during cell metallization can be reduced, also facilitating the improvement of the cell efficiency.

In practical application, during preparation of the P-type doped polysilicon layer 2 and the N-type doped polysilicon layer 3, intrinsic amorphous silicon can be deposited first, then doping diffusion can be performed, and a high-temperature treatment can be performed during doping diffusion. By controlling diffusion temperatures and diffusion times of the P-type doped polysilicon layer 2 and the N-type doped polysilicon layer 3, the average grain sizes of the P-type doped polysilicon layer 2 and the N-type doped polysilicon layer 3 can be precisely regulated. For example, a higher doping diffusion temperature of the P-type doped polysilicon layer 2 can be set, and a longer diffusion time can be set, such that the average grain size of the P-type doped polysilicon layer 2 can be greater than the average grain size of the N-type doped polysilicon layer 3.

As an embodiment of the present disclosure, a ratio of the average grain size of the P-type doped polysilicon layer 2 to the average grain size of the N-type doped polysilicon layer 3 is 1-4, and is not equal to 1.

In this embodiment, the ratio of the average grain size of the P-type doped polysilicon layer 2 to the average grain size of the N-type doped polysilicon layer 3 is greater than 1 and less than or equal to 4, such that it can ensure that a difference between the average grain size of the P-type doped polysilicon layer 2 and the average grain size of the N-type doped polysilicon layer 3 is within an appropriate range, then the sheet resistance of the P-type region can be reduced, and the cell efficiency can be improved, and the preparation of the P-type doped polysilicon layer 2 and the N-type doped polysilicon layer 3 can be facilitated.

As an embodiment of the present disclosure, the average grain size of the P-type doped polysilicon layer 2 is 50-600 nm, and the average grain size of the N-type doped polysilicon layer 3 is 10-400 nm, such that the preparation of the P-type doped polysilicon layer 2 and the N-type doped polysilicon layer 3 can be facilitated.

Referring to Fig. 2, as an embodiment of the present disclosure, there is a first height difference h1 between a surface of the P-type doped polysilicon layer 2 close to the silicon substrate 1 and a surface of the N-type doped polysilicon layer 3 close to the silicon substrate 1, and the surface of the P-type doped polysilicon layer 2 close to the silicon substrate 1 is further away from the front side of the silicon substrate 1 than the surface of the N-type doped polysilicon layer 3 close to the silicon substrate 1.

In this embodiment, a surface of the silicon substrate 1 close to the P-type doped polysilicon layer 2 and a surface of the silicon substrate 1 close to the N-type doped polysilicon layer 3 are not on the same plane. The surface of the P-type doped polysilicon layer 2 close to the silicon substrate 1 is further away from the front side of the silicon substrate 1 than the surface of the N-type doped polysilicon layer 3 close to the silicon substrate 1, such that the surface of the P-type doped polysilicon layer 2 close to the silicon substrate 1 has the first height difference h1 with the surface of the N-type doped polysilicon layer 3 close to the silicon substrate 1. Therefore, the control of the relative position of the P-type doped polysilicon layer 2 and the N-type doped polysilicon layer 3 can be more accurate, and position reference can be more accurate. Furthermore, before manufacturing a next doped polysilicon layer, a portion of a previous doped polysilicon layer to be etched can be etched more cleanly, and the P-type doped polysilicon layer 2 and the N-type doped polysilicon layer 3 in a gap between the first region and the second region both can be etched more cleanly, such that electrical performance can be better. The first height difference h1 can be flexibly set according to actual requirements, and is not limited herein.

As an embodiment of the present disclosure, there is a second height difference h2 between the surface of the P-type doped polysilicon layer 2 close to the silicon substrate 1 and a surface of the N-type doped polysilicon layer 3 far away from the silicon substrate 1, and the surface of the P-type doped polysilicon layer 2 close to the silicon substrate 1 is further away from the front side of the silicon substrate 1 than the surface of the N-type doped polysilicon layer 3 far away from the silicon substrate 1.

In this embodiment, a surface of the P-type doped polysilicon layer 2 far away from the silicon substrate 1 is further away from the front side of the silicon substrate 1 than the surface of the N-type doped polysilicon layer 3 far away from the silicon substrate 1, and the surface of the P-type doped polysilicon layer 2 far away from the silicon substrate 1 has the second height difference h2 with the surface of the N-type doped polysilicon layer 3 far away from the silicon substrate 1, such that a good electrical isolation effect of the P-type doped polysilicon layer 2 and the N-type doped polysilicon layer 3 is achieved, and risks of short circuits and leakage of electricity are lower. The second height difference h2 can be flexibly set according to actual requirements, and is not limited herein.

As an embodiment of the present disclosure, a textured structure (not shown in the figure) can also be provided on the front side of the silicon substrate 1, and by the textured structure, a good light trapping effect can be achieved, thereby improving the conversion efficiency of the back contact solar cell.

As an embodiment of the present disclosure, a front-side passivation anti-reflection film layer 9 is also provided on the front side of the back contact solar cell, so as to further reduce light reflex, thereby further improving the conversion efficiency of the back contact solar cell.

As an embodiment of the present disclosure, the back contact solar cell further includes back-side passivation film layers 5 that are located on a back side of the P-type doped polysilicon layer 2 and a back side of the N-type doped polysilicon layer 3. The metallic crystal of the first metal electrode 6 enters the P-type doped polysilicon layer 2 by passing through the back-side passivation film layer 5, and the metallic crystal of the second metal electrode 7 enters the N-type doped polysilicon layer 3 by passing through the back-side passivation film layer 5. By providing the back-side passivation film layer 5, a back-side passivation effect of the cell can be further improved, thereby further improving the conversion efficiency of the back contact solar cell.

As an embodiment of the present disclosure, the silicon substrate 1 further includes grooves 8, each groove 8 is located between the P-type doped polysilicon layer 2 and the N-type doped polysilicon layer 3. With the groove 8 to perform physical isolation on the P-type doped polysilicon layer 2 and the N-type doped polysilicon layer 3, the isolation effect of the P-type doped polysilicon layer 2 and the N-type doped polysilicon layer 3 can be further improved, thereby further reducing the risks of short circuit or leakage of electricity. A width of the groove 8 can be flexibly set according to actual requirements, and is not limited herein.

An embodiment of the present disclosure further provides a cell assembly. The cell assembly includes the back contact solar cell in the above embodiments. It is to be noted that, the cell assembly and the back contact solar cell have the same or similar beneficial effects and can be cross-referenced for relevance, which is not described herein again to avoid repetition.

An embodiment of the present disclosure further provides a photovoltaic system. The photovoltaic system includes the cell assembly in the above embodiment. It is to be noted that, the cell assembly and the back contact solar cell have the same or similar beneficial effects and can be cross-referenced for relevance, which is not described herein again to avoid repetition.

In the back contact solar cell provided in the embodiments of the present disclosure, by setting the depth of the metallic crystal of the first metal electrode entering the P-type doped polysilicon layer to be greater than the depth of the metallic crystal of the second metal electrode entering the N-type doped polysilicon layer, with the depth of the metallic crystal of the second metal electrode entering the N-type doped polysilicon layer unchanged, a contact area of the metallic crystal of the first metal electrode and the P-type doped polysilicon layer can be increased by increasing the depth of the metallic crystal of the first metal electrode entering the P-type doped polysilicon layer, such that contact effect of the first metal electrode and the P-type doped polysilicon layer can be improved, and a desirable ohmic contact can be realized, then the conductive performance of the first metal electrode and the P-type doped polysilicon layer can be improved, thereby improving conversion efficiency of the cell.

The above are merely preferred embodiments of the present disclosure, but are not intended to limit the present disclosure. Any modification, equivalent replacement, improvement, or the like made within the spirit and principle of the present disclosure should fall within the protection scope of the present disclosure.

## Claims

1. A back contact solar cell, comprising:
a silicon substrate, comprising a back side and a front side, which are opposite to each other;
a P-type doped polysilicon layer, located in a first region of the back side of the silicon substrate;
an N-type doped polysilicon layer, located in a second region of the back side of the silicon substrate, wherein the first region is different from the second region;
a first metal electrode disposed in the first region and in contact with the P-type doped polysilicon layer; and
a second metal electrode disposed in the second region and in contact with the N-type doped polysilicon layer;
wherein a depth of a metallic crystal of the first metal electrode entering the P-type doped polysilicon layer is greater than a depth of a metallic crystal of the second metal electrode entering the N-type doped polysilicon layer.

2. The back contact solar cell according to claim 1, wherein a ratio of the depth of the metallic crystal of the first metal electrode entering the P-type doped polysilicon layer to the depth of the metallic crystal of the second metal electrode entering the N-type doped polysilicon layer is 1-4, and is not equal to 1.

3. The back contact solar cell according to claim 1, wherein a ratio of the depth of the metallic crystal of the first metal electrode entering the P-type doped polysilicon layer to the depth of the metallic crystal of the second metal electrode entering the N-type doped polysilicon layer is 1 to 2, and is not equal to 1.

4. The back contact solar cell according to claim 1, wherein the depth of the metallic crystal of the first metal electrode entering the P-type doped polysilicon layer is 2-300 nm; and the depth of the metallic crystal of the second metal electrode entering the N-type doped polysilicon layer is 1-200 nm.

5. The back contact solar cell according to claim 1, wherein materials of the first metal electrode and materials of the second metal electrode both comprise silver, at least one kind of glass frit, and at least one kind of organic material, and a mass content of the at least one kind of glass frit in the first metal electrode is greater than a mass content of the at least one kind of glass frit in the second metal electrode.

6. The back contact solar cell according to claim 1, wherein a refractive index of the P-type doped polysilicon layer is less than a refractive index of the N-type doped polysilicon layer.

7. The back contact solar cell according to claim 1, further comprising a back-side passivation film layer that is located on a back side of the P-type doped polysilicon layer and a back side of the N-type doped polysilicon layer, wherein the metallic crystal of the first metal electrode enters the P-type doped polysilicon layer by passing through the back-side passivation film layer, and the metallic crystal of the second metal electrode enters the N-type doped polysilicon layer by passing through the back-side passivation film layer.

8. The back contact solar cell according to claim 1, wherein an average grain size of the P-type doped polysilicon layer is greater than an average grain size of the N-type doped polysilicon layer.

9. The back contact solar cell according to claim 8, wherein a ratio of the average grain size of the P-type doped polysilicon layer to the average grain size of the N-type doped polysilicon layer is 1-4, and is not equal to 1.

10. The back contact solar cell according to claim 1, wherein a thickness of the P-type doped polysilicon layer is greater than a thickness of the N-type doped polysilicon layer.

11. The back contact solar cell according to claim 10, wherein a ratio of the thickness of the P-type doped polysilicon layer to the thickness of the N-type doped polysilicon layer is 1-2, and is not equal to 1.

12. A cell assembly, comprising the back contact cell according to any one of claims 1 to 11.

13. A photovoltaic system, comprising the cell assembly according to claim 12.
